# EUROPÄISCHE PATENTANMELDUNG

(11) **EP 4 431 969 A1**
(43) Veröffentlichungstag der Anmeldung: **18.09.2024**
(21) Anmeldenummer: 23162376.0
(22) Anmeldetag: 16.03.2023
(51) Int. Cl.: G01R 33/565

(54) **VERFAHREN ZUM KALIBRIEREN EINER BEWEGUNGSDETEKTIONSMETHODE, LOKALSPULE, MAGNETRESONANZVORRICHTUNG UND COMPUTERPROGRAMMPRODUKT**

(71) Anmelder: Siemens Healthineers AG, 91301 Forchheim (DE)
(72) Erfinder: Bacher, Mario, 91227 Diepersdorf (DE); Speier, Peter, 91056 Erlangen (DE); Sukkau, Johann, 91074 Herzogenaurach (DE)
(74) Vertreter: Siemens Healthineers Patent Attorneys

(57) **Zusammenfassung**

Die Erfindung betrifft ein Verfahren zum Kalibrieren einer Bewegungsdetektionsmethode, eine Lokalspule (26), eine Magnetresonanzvorrichtung (10) und ein Computerprogrammprodukt. Die Bewegungsdetektionsmethode ist geeignet, eine Bewegung eines Untersuchungsobjekts (15) während einer Magnetresonanzmessung mittels einer Magnetresonanzvorrichtung (10) zu detektieren. Es werden in einem Erfassungszeitraum erste Bewegungsdaten des Untersuchungsobjekts (15) gemäß der Bewegungsdetektionsmethode erfasst. Außerdem werden in dem Erfassungszeitraum zweite Bewegungsdaten des Untersuchungsobjekts (15) gemäß zumindest einer weiteren Bewegungsdetektionsmethode erfasst. Die Bewegungsdetektionsmethode wird anhand der ersten Bewegungsdaten und der zweiten Bewegungsdaten kalibriert.

## Beschreibung

Die Erfindung betrifft ein Verfahren zum Kalibrieren einer Bewegungsdetektionsmethode, eine Lokalspule, eine Magnetresonanzvorrichtung und ein Computerprogrammprodukt.

In der Medizintechnik zeichnet sich die Bildgebung mittels Magnetresonanz (MR), auch Magnetresonanztomographie (MRT, engl. Magnetic Resonance Imaging, MRI) genannt, durch hohe Weichteilkontraste aus. Hierbei wird typischerweise ein Untersuchungsobjekt, beispielsweise ein Patient, in einem statischen, homogenen Magnetfeld einer MR-Vorrichtung positioniert. Während einer MR-Messung werden gemäß einer MR-Sequenz üblicherweise hochfrequente (HF, engl. RF) Sendepulse in das Untersuchungsobjekt eingestrahlt. Durch die erzeugten Sendepulse werden in Verbindung mit dem statischen Magnetfeld im Untersuchungsobjekt Kernspins angeregt, wodurch durch Gradientenpulse ortskodierte MR-Signale ausgelöst werden. Die MR-Signale werden von der MR-Vorrichtung empfangen und zur Rekonstruktion von MR-Abbildungen verwendet.

Um eine höhere Qualität der MR-Abbildungen zu erreichen, werden während der MR-Messung vorzugsweise Bewegungsdaten aufgenommen, die eine mögliche Bewegung des Untersuchungsobjekts beschreiben. Anhand dieser kann beispielweise eine prospektive oder retrospektive Bewegungskorrektur vorgenommen werden. Ferner können Bewegungsdaten für eine Steuerung, insbesondere Synchronisierung, der MR-Sequenz mit der Patientenbewegung verwendet werden.

Zur Erfassung von Bewegungsdaten wurde in den vergangenen Jahren eine Technik eingeführt, die einen Pilotton (PT) einsetzt und beispielsweise in den Druckschriften US 20160245888 A1, US 20170160364 A1 und US 20180353139 A1 beschrieben wird.

Dabei wird mit einem PT-Generator ein PT-Signal ausgesendet, das durch eine Bewegung des Untersuchungsobjekts moduliert und von einer HF-Empfangseinheit der MR-Vorrichtung empfangen wird. Vorteilhafterweise weist die HF-Empfangseinheit eine Empfangsbandbreite auf, die groß genug ist, um gleichzeitig das MR-Signal und PT-Signal, das nicht im Frequenzbereich des MR-Signals liegt, zu empfangen. Die HF-Empfangseinheit kann mehrere Empfangselemente, insbesondere Spulenelemente, umfassen, die jeweils einem Empfangskanal zugeordnet sind.

Das empfangene PT-Signal kann insbesondere als eine Matrix dargestellt werden, deren Matrixelemente, insbesondere deren Dimensionen, die Zeit und/oder verschiedene Empfangskanäle des PT-Signals abbilden. Die PT-Signale jedes Empfangskanals können Informationen verschiedener Bewegungsbestandteile, wie beispielsweise Atembewegung und Herzbewegung, beinhalten. Von den Bewegungsbestandteilen jeweils hervorgerufene PT-Teilsignale können sich im PT-Signal, insbesondere linear, vermischen; diese Mischung der PT-Teilsignale kann insbesondere durch eine Mischungs-Matrix beschrieben werden. Diese Mischungs-Matrix ist jedoch a priori nicht bekannt, so dass die zunächst kalibriert werden muss.

Neben der PT-Technik sind weitere Bewegungsdetektionsmethoden bekannt, wie beispielsweise eine Bewegungsdetektion mittels MR-Navigatoren und/oder einer Kamera. Vorteilhafterweise werden auch solche weitere Bewegungsdetektionsmethoden kalibriert, um eine Bewegungsdetektion, insbesondere hinsichtlich ihrer Genauigkeit, zu verbessern.

Als Aufgabe der vorliegenden Erfindung kann angesehen werden, ein Verfahren zum Kalibrieren einer Bewegungsdetektionsmethode anzugeben, das vorteilhafterweise besonders robust ist. Die Aufgabe wird durch die Merkmale der unabhängigen Ansprüche gelöst. Vorteilhafte Ausgestaltungen sind in den abhängigen Ansprüchen beschrieben. Unabhängig vom grammatikalischen Geschlecht eines bestimmten Begriffes sind Personen mit männlicher, weiblicher oder anderer Geschlechteridentität mit umfasst.

Es wird ein Verfahren zum Kalibrieren einer Bewegungsdetektionsmethode, BDM, vorgeschlagen, wobei die BDM geeignet ist, eine Bewegung eines Untersuchungsobjekts während einer Magnetresonanzmessung mittels einer Magnetresonanzvorrichtung zu detektieren. Es werden dazu in einem Erfassungszeitraum erste Bewegungsdaten des Untersuchungsobjekts gemäß der BDM erfasst, insbesondere aufgenommen und/oder gemessen und/oder akquiriert. Es werden während des Erfassens der ersten Bewegungsdaten, also in dem Erfassungszeitraum, zudem zweite Bewegungsdaten des Untersuchungsobjekts gemäß zumindest einer weiteren Bewegungsdetektionsmethode, WBDM, erfasst, insbesondere aufgenommen und/oder gemessen und/oder akquiriert. Die BDM wird anhand der ersten Bewegungsdaten und der zweiten Bewegungsdaten kalibriert, insbesondere angepasst und/oder trainiert.

Vorzugsweise erfolgt das Erfassen der zweiten Bewegungsdaten durchgehend und/oder kontinuierlich und/oder ohne signifikante Pausen im Erfassungszeitraum.

Vorzugsweise werden die ersten und zweiten Bewegungsdaten in einer Kalibrierungsphase, insbesondere Lernphase, erfasst. Die Kalibrierungsphase kann beispielsweise 10 bis 20 Sekunden dauern. Vorzugsweise werden die ersten und zweiten Bewegungsdaten zeitgleich und/oder parallel erfasst.

Vorzugsweise werden die zweiten Bewegungsdaten in einem Direktzugriffsspeicher (eng. Random-Access Memory, RAM) der Magnetresonanzvorrichtung gespeichert.

Die zumindest eine WBDM ist vorzugsweise eine andere Methode als die BDM. Die zumindest eine WBDM ist vorzugsweise eine von der BDM unabhängige Methode. Vorzugsweise beruht die Erzeugung der zweiten Bewegungsdaten auf einem anderen physikalischen Vorgang und/oder einer anderen Wechselwirkung und/oder einem anderen Prinzip als die Erzeugung der ersten Bewegungsdaten. Vorzugsweise können etwaige Messfehler der BDM mit Hilfe der WBDM erkannt werden.

Vorzugsweise umfasst das Kalibrieren der BDM anhand der ersten Bewegungsdaten und der zweiten Bewegungsdaten ein Identifizieren zumindest eines Störungszeitraums in dem gesagten Erfassungszeitraum (also während des Erfassens der ersten Bewegungsdaten und der zweiten Bewegungsdaten), in dem die Bewegung des Untersuchungsobjekts eine Störung aufweist, wobei die BDM unter Berücksichtigung des zumindest einen Störungszeitraums kalibriert werden. Insbesondere werden die ersten und/oder zweiten Bewegungsdaten, die innerhalb des zumindest einen Störungszeitraums liegen, in anderer Weise bei der Kalibrierung berücksichtigt als die ersten und/oder zweiten Bewegungsdaten, die außerhalb des zumindest einen Störungszeitraums liegen. Vorzugsweise erfolgt das Identifizieren zumindest eines Störungszeitraums anhand der zweiten Bewegungsdaten.

Beispielsweise erfolgt das Erfassen der ersten und zweiten Bewegungsdaten in einem Erfassungszeitraum zwischen den Zeitpunkten tᵢ und t_{f}; zum Zeitpunkt t₁ ≥ tᵢ beginnt eine Störung, zum Zeitpunkt t₂ ≤ t_{f} endet die Störung. Dann kann die BDM unter Berücksichtigung des Zeitraums von t₁ bis t₂ kalibriert werden.

Vorzugsweise umfasst das Identifizieren des zumindest einen Störungszeitraums ein Identifizieren zumindest einer Bewegungsabweichung anhand der zweiten Bewegungsdaten, insbesondere zumindest eines vorbestimmten Bewegungsmuster in den zweiten Bewegungsdaten.

Die zweiten Bewegungsdaten können beispielsweise eine Bewegungsamplitude beschreiben, welche eine Amplitude der Bewegung des Untersuchungsobjekts beschreiben. Die zumindest eine Bewegungsabweichung kann beispielsweise dadurch festgelegt sein, dass die Bewegungsamplitude einen vorbestimmten Schwellwert überschreitet. Der Schwellwert kann insbesondere relativ zu einer durchschnittlichen Bewegungsamplitude festgelegt sein.

Beispielsweise umfasst das zumindest eine vorbestimmte Bewegungsmuster ein Bewegungsmuster, das eine Unregelmäßigkeit, insbesondere eine Signalspitze in der Bewegungsamplitude beschreibt.

Beispielweise werden die ersten Bewegungsdaten, die in dem zumindest einen Störungszeitraum erfasst wurden, bei dem Kalibrieren der BDM ignoriert. Vorzugsweise erfolgt das Kalibrieren der BDM außerschließlich anhand der außerhalb des zumindest einen Störungszeitraums erfassten ersten Bewegungsdaten.

Beispielweise werden die ersten Bewegungsdaten, die in dem zumindest einen Störungszeitraum erfasst wurden, bei dem Kalibrieren der BDM anders gewichtet als die sonstigen ersten Bewegungsdaten.

Vorzugsweise wird dem zumindest einen Störungszeitraum jeweils ein Störungsstärke zugeordnet, die eine Stärke der Störung angibt. Insbesondere werden die ersten Bewegungsdaten, die in dem zumindest einen Störungszeitraum erfasst wurden, bei dem Kalibrieren der BDM gemäß der zugeordneten Störungsstärke gewichtet.

Vorzugsweise werden die ersten Bewegungsdaten werden anhand der zweiten Bewegungsdaten modifiziert, insbesondere angepasst und/oder verändert. Vorzugsweise wird die BDM anhand der modifizierten ersten Bewegungsdaten kalibriert.

Vorteilhafterweise werden beim Modifizieren der ersten Bewegungsdaten anhand der zweiten Bewegungsdaten korrumpierte erste Bewegungsdaten, die beispielsweise durch etwaige Messfehler verursacht wurden, aus den ersten Bewegungsdaten entfernt. Korrumpierte erste Bewegungsdaten können beispielsweise durch eine oder mehrere unbeabsichtigte Bewegungen des Untersuchungsobjekts verursacht sein. Die modifizierten ersten Bewegungsdaten sind vorteilhafterweise von Messfehlern bereinigte Bewegungsdaten. Vorteilhafterweise kann anhand solcher modifizierter erster Bewegungsdaten das Kalibrieren der BDM zuverlässiger durchgeführt werden.

Beispielsweise umfasst das Modifizieren der ersten Bewegungsdaten ein Entfernen der ersten Bewegungsdaten innerhalb des zumindest eines Störungszeitraums aus den ersten Bewegungsdaten. Bezogen auf das oben genannte Beispiel können insbesondere ersten Bewegungsdaten, die im Zeitraum von t₁ bis t₂ erfasst wurden aus den ersten Bewegungsdaten entfernt werden.

Vorzugsweise umfasst die Bewegung des Untersuchungsobjekts zumindest zwei Bewegungsbestandteile, insbesondere zwei Bewegungskomponenten.

Ein Bewegungsbestandteil ist insbesondere einer spezifischen Bewegungsart zugeordnet. Mehrere Bewegungsarten können gleichzeitig im Körper des Untersuchungsobjekts stattfinden, z.B. Herzbewegung, Atembewegung und andere willkürliche oder unwillkürliche Bewegungen des Patienten, z.B. Drehen des Kopfes, Bewegen der Hand oder der Beine usw. Das kalibrierte BDM kann insbesondere angewendet werden, um zumindest einen der zumindest zwei Bewegungsbestandteile aus Bewegungsdaten zu extrahieren, die beispielsweise in einer sich der Kalibrierungsphase anschließenden Messphase gemäß der BDM erfasst werden.

Zur Kalibrierung der BDM werden beispielsweise PT-Signale als erste Bewegungsdaten in der Kalibrierungsphase erfasst. Vorzugsweise soll das Untersuchungsobjekt, insbesondere der Patient, in der Kalibrierungsphase möglichst normal atmen. Anhand der erfassten ersten Bewegungsdaten kann vorteilhafterweise eine Entmischungslösung berechnet werden, die geeignet ist, die zumindest zwei Bewegungsbestandteile zu trennen. Ein Bewegungsbestandteil der zumindest zwei Bewegungsbestandteile kann beispielsweise eine Atembewegung, eine Herzbewegung, eine Kopfbewegung oder eine Bewegung des gesamten Körpers des Patienten sein. Die Berechnung der Entmischungslösung kann vorteilhafterweise durch die Berücksichtigung der zweiten Bewegungsdaten genauer durchgeführt werden.

Vorzugsweise umfasst das Kalibrieren der BDM ein Kalibrieren eines BSS-Algorithmus (BSS: Blind Signal Separation) zum Separieren der zumindest zwei Bewegungsbestandteile.

Beispielsweise umfasst der BSS-Algorithmus einen ICA-Algorithmus (ICA: Independent Component Analysis) und/oder einen PCA-Algorithmus (PCA: Principal Component Analysis), insbesondere einen cPCA-Algorithmus (cPCA: complex Principal Component Analysis).

Beispielsweise umfassen die zumindest zwei Bewegungsbestandteile eine Herzbewegung und/oder eine Atembewegung des Untersuchungsobjekts.

Als Herzbewegung kann insbesondere jede Bewegung bezeichnet werden, die durch eine regelmäßige Kontraktion des Herzmuskels verursacht wird, sei es im Herzen selbst oder in anderen davon betroffenen Körperteilen, insbesondere mittels arterieller Blutgefäße. Als Atembewegung kann insbesondere jede Bewegung bezeichnet werden, die durch ein regelmäßiges Füllen bzw. Leeren der Lungen mit Luft verursacht wird, sei es in der Brust und oder im Bauch selbst oder in anderen davon betroffenen Körperteilen.

Die Anwendung eines ICA-Algorithmus sieht insbesondere vor, dass eine Entmischungsmatrix aus einem Kalibrierungsanteil von Bewegungsdaten, beispielsweise eines PT-Signals, berechnet wird. Der ICA-Algorithmus kann insbesondere auf mehrere Bewegungsdaten angewendet werden, beispielsweise durch verschiedene Empfangskanäle erfasst werden. Vorzugsweise trennt eine Entmischungsmatrix Signale unterschiedlicher Bewegungsarten in den Bewegungsdaten. (Soll ein Signal nur einer Bewegungsart aus den Bewegungsdaten extrahiert werden, kann dies auch mit Hilfe eines Entmischungsvektors erfolgen.)

Beispielsweise trennt die Entmischungs-Matrix, wenn sie auf ein PT-Signal angewendet wird, mindestens einen bestimmten Bewegungstyp, darunter vorzugsweise die Herzkomponente, von weiteren möglichen Signalkomponenten. Abhängig von der Implementierung des ICA-Algorithmus kann diese Entmischungs-Matrix entweder komplex oder reellwertig sein. Hinsichtlich weiterer möglicher Aspekte des ICA-Algorithmus oder des PCA-Algorithmus sei auf die Druckschrift EP3413076A1 verwiesen.

Vorzugsweise werden die zweiten Bewegungsdaten mit zumindest einem Sensor, insbesondere Bewegungssensor, erfasst. Vorzugsweise werden die zweiten Bewegungsdaten mit zumindest einem Sensor erfasst, der durch die Bewegung des Untersuchungsobjekts, insbesondere durch eine Bewegung einer Brust des Untersuchungsobjekts, mitbewegt wird.

Insbesondere beschreiben die zweiten Bewegungsdaten eine Position des zumindest einen Sensors in Bezug auf die Magnetresonanzvorrichtung, insbesondere auf ein Magnetfeld, insbesondere das Hauptmagnetfeld (B0-Feld) und/oder ein Gradientenmagnetfeld der Magnetresonanzvorrichtung, und/oder die Beschleunigung des zumindest einen Sensors.

Insbesondere werden die zweiten Bewegungsdaten mit zumindest einem Sensor erfasst, der in oder an einer am Untersuchobjekt angebrachten Komponente der Magnetresonanzvorrichtung, beispielsweise eine Lokalspule, angeordnet ist, die durch die Bewegung des Untersuchungsobjekts, insbesondere durch eine Bewegung einer Brust des Untersuchungsobjekts, mitbewegt wird.

Insbesondere beschreiben die zweiten Bewegungsdaten eine Position der Lokalspule in Bezug auf die Magnetresonanzvorrichtung, insbesondere auf das Hauptmagnetfeld der Magnetresonanzvorrichtung, und/oder die Beschleunigung der Lokalspule.

Vorzugsweise umfasst der zumindest eine Sensor einen Magnetfeld-Sensor, insbesondere einen Hall-Sensor, insbesondere 3D-Hallsensor, und/oder einen Beschleunigungssensor und/oder einen Gyro-Sensor.

Insbesondere erzeugt der Hall-Sensor durch eine Bewegung im Magnetfeld der Magnetresonanzvorrichtung zumindest einen Teil der zweiten Bewegungsdaten. Ein Hall-Sensor (auch Hall-Sonde oder Hall-Geber, nach Edwin Hall) nutzt den Hall-Effekt grundsätzlich zur Messung von Magnetfeldern. Vor allem außerhalb des Sichtfeldes (engl. field of view, FOV), insbesondere außerhalb eines etwaigen Tunnels (engl. bore) der Magnetresonanzvorrichtung, ist die räumliche Verteilung des Magnetfeldes vorteilhafterweise inhomogen, aber bekannt, so dass sich mittels einer durch den Hall-Sensor gemessenen Stärke des Magnetfeldes die räumliche Position des Hall-Sensors bestimmt werden kann.

Vorzugsweise werden die zweiten Bewegungsdaten, insbesondere Translationsdaten und/oder Rotationsdaten, zumindest zum Teil außerhalb eines Tunnels der Magnetresonanzvorrichtung erfasst.

Vorteilhafterweise können außerhalb des Tunnels, wegen der üblicherweise großen Inhomogenität des Hauptmagnetfeldes in diesem Bereich, Translationsdaten (z.B. x-, y- und/oder z-Daten) und/oder Rotationsdaten (z.B. Roll-, Pitch-, und/oder Yaw-Daten) als zweite Bewegungsdaten mittels eines Hall-Sensors besonders gut erfasst werden. Vorteilhafterweise kann durch eine zeitabhängige Erfassung einer Drehbewegung mittels des Hall-Sensors auch eine Winkelgeschwindigkeit berechnet werden.

Zudem können zweite Bewegungsdaten durch Messung eines Gradientenmagnetfeldes mittels Magnetfeld-Sensoren erfasst werden. Eine solche Messung würde vorteilhafterweise innerhalb des Tunnels erfolgen, in dem das Gradientenmagnetfeld erzeugt wird. Diesbezüglich sei auf die Druckschrift US20100176809A1 verwiesen, in der dargestellt wird, wie mittels einer Anzahl von Magnetfeld-Sensoren zur Messung eines Gradientenmagnetfeldes eine räumliche Lokalisierung einer Lokalspule durchgeführt wird.

Ein Beschleunigungssensor (auch Beschleunigungsmesser, Beschleunigungsaufnehmer, Vibrationsaufnehmer, Schwingungsaufnehmer, Accelerometer, Akzelerometer, B-Messer oder G-Sensor) ist ein Sensor, der seine Beschleunigung misst. Der Beschleunigungssensor liefert vorzugswerte Beschleunigungswerte in drei Raumrichtungen.

Ein Gyro-Sensor ist vorteilhafterweise ausgebildet, Winkelgeschwindigkeiten zu messen. Mit einem Gyro-Sensor kann vorteilhafterweise eine dynamische Beschleunigung durch die Bewegung des Untersuchungsobjekts bzw. des Beschleunigungssensors und eine statische Beschleunigung durch die Gravitation der Erde getrennt werden.

Vorzugsweise umfasst der zumindest eine Sensor mehrere Sensoren, die jeweils auf einer anderen physikalischen Wechselwirkung zur Detektion der Bewegung des Untersuchungsobjekts beruhen. Insbesondere stellen die mehreren Sensoren jeweils einen Teil der zweiten Bewegungsdaten bereit. Vorteilhafterweise beruht der zumindest eine Sensor zur Detektion der Bewegung des Untersuchungsobjekts auf einer anderen Wechselwirkung als die BDM. Beispielsweise beruht eine PT-Methode als BDM auf einer elektromagnetischen Wechselwirkung eines PT-Feldes mit leitfähigem Gewebe, wohingegen mit einem Hall-Sensor ein Magnetfeld, insbesondere ein Hauptmagnetfeld der Magnetresonanzvorrichtung, gemessen wird, oder mit einem Beschleunigungs-Sensor eine Beschleunigung. Vorteilhafterweise kann durch eine Kombination mehrerer Sensoren - beispielsweise eines Hall-Sensors, eines Beschleunigungs-Sensors und eines Gyro-Sensors - eine Redundanz der Sensordaten erreicht werden.

Beispielsweise beruhen der Magnetfeld-Sensor, insbesondere Hall-Sensor, und Beschleunigungssensor auf unterschiedlichen physikalischen Wechselwirkungen zur Detektion der Bewegung des Untersuchungsobjekts. Dadurch kann das Kalibrieren der BDM, insbesondere das Identifizieren des zumindest einen Störungszeitraums, robuster erfolgen.

Insbesondere können die jeweiligen Bewegungsdaten der verschiedenen Sensoren miteinander korreliert werden, um eine verlässlichere Auswertung der zweiten Bewegungsdaten zu ermöglichen.

Vorzugsweise umfasst die BDM eine Wechselwirkung eines Pilotton-Signals mit dem sich bewegenden Untersuchungsobjekt. Vorzugsweise ist die BDM eine PT-Methode. Dabei wird mit einem PT-Generator ein PT-Signal ausgesendet, das durch eine Bewegung des Untersuchungsobjekts moduliert und von der Magnetresonanzvorrichtung erfasst wird. Vorteilhafterweise weist die Magnetresonanzvorrichtung eine Empfangsbandbreite auf, die groß genug ist, um gleichzeitig ein MR-Signal und ein PT-Signal, das nicht im Frequenzbereich des MR-Signals liegt, zu empfangen. Die Magnetresonanzvorrichtung kann mehrere Empfangselemente, insbesondere Spulenelemente, umfassen, die jeweils einem Empfangskanal zugeordnet sind.

Das empfangene PT-Signal kann insbesondere als eine Matrix dargestellt werden, deren Matrixelemente die Zeit und/oder verschiedene Empfangskanäle des PT-Signals abbilden. Die PT-Signale jedes Empfangskanals können Informationen verschiedener Bewegungsbestandteile, wie beispielsweise Atembewegung und Herzbewegung, beinhalten. Von den Bewegungsbestandteilen jeweils hervorgerufene PT-Teilsignale können sich im PT-Signal, insbesondere linear, vermischen; diese Mischung der PT-Teilsignale kann insbesondere durch eine Mischungs-Matrix beschrieben werden. Die Mischungs-Matrix kann insbesondere durch die Geometrie und die Sensitivität der Spulenelemente festgelegt sein. Vorteilhafterweise umfasst das Kalibrieren der BDM anhand der ersten Bewegungsdaten und der zweiten Bewegungsdaten ein Kalibrieren der Mischungs-Matrix. Insbesondere wird anhand der ersten Bewegungsdaten und der zweiten Bewegungsdaten eine Entmischungs-Matrix bestimmt.

Eine mögliche Ausführungsform des Verfahrens sieht vor, dass das Verfahren ferner umfasst:
- Überprüfen anhand der zweiten Bewegungsdaten, ob die Bewegung des Untersuchungsobjekts im Erfassungszeitraum zumindest einem vorgegebenen Kriterium entspricht,
- falls das Überprüfen ergibt, dass die Bewegung eines Untersuchungsobjekts im Erfassungszeitraum nicht dem zumindest einen vorgegebenen Kriterium entspricht: wiederholtes Erfassen weiterer erster und zweiter Bewegungsdaten und Kalibrieren der BDM anhand der weiteren ersten und zweiten Bewegungsdaten.

Das zumindest eine vorgegebene Kriterium kann insbesondere vorgeben, dass die Bewegung eines Untersuchungsobjekts im Erfassungszeitraum hinreichend regelmäßig ist. Insbesondere kann das zumindest eine vorgegebene Kriterium vorgeben, dass der Zeitraum im Erfassungszeitraum, in dem die Bewegung eines Untersuchungsobjekts im Erfassungszeitraum hinreichend regelmäßig ist, insbesondere einen vorgegebenen Schwellwert nicht überschreitet. Ein solcher Schwellwert kann beispielsweise eine bestimmte Amplitude der Bewegung des Untersuchungsobjekts (z.B. eine absolute Bewegung in der Einheit "cm") und/oder eine bestimmte Beschleunigung sein. Vorteilhafterweise kann mittels des Amplitudenkriteriums ein sehr tiefes Luftholen des Patienten detektiert werden. Vorteilhafterweise kann mittels des Beschleunigungskriteriums ein Husten oder Nießen des Patienten detektiert werden. Solche Kriterien können auch kombiniert werden.

Vorteilhafterweise kann durch das Überprüfen sichergestellt werden, dass Qualität und/oder Quantität der erfassten ersten Bewegungsdaten ausreichend ist, um das Kalibrieren der BDM (erfolgreich) durchzuführen.

Es ist beispielsweise auch denkbar, dass durch Bewegung kompromittierte Zeiträume identifiziert werden und die in diesen Zeiträumen liegenden ersten Bewegungsdaten entfernt werden. Falls die daraus resultierenden ersten Bewegungsdaten noch ausreichend Daten enthalten, kann vorteilhafterweise auf das wiederholte Erfassen weiterer erster und zweiter Bewegungsdaten verzichtet werden.

Ferner wird eine Lokalspule mit zumindest einem Sensor zur Erfassung zweiter Bewegungsdaten vorgeschlagen, um damit ein vorab beschriebenes Verfahren auszuführen. Ferner wird eine Magnetresonanzvorrichtung, insbesondere mit einer solchen Lokalspule, vorgeschlagen, die ausgebildet ist, ein vorab beschriebenes Verfahren auszuführen.

Die Vorteile der vorgeschlagenen Lokalspule und der vorgeschlagenen Magnetresonanzvorrichtung entsprechen im Wesentlichen den Vorteilen des vorgeschlagenen Verfahrens zum Kalibrieren einer Bewegungsdetektionsmethode, welche vorab im Detail ausgeführt sind. Hierbei erwähnte Merkmale, Vorteile oder alternative Ausführungsformen können ebenso auch auf die anderen beanspruchten Gegenstände übertragen werden und umgekehrt.

Ferner wird ein Computerprogrammprodukt vorgeschlagen, das ein Programm umfasst und direkt in einen Speicher einer programmierbaren Systemsteuereinheit einer Magnetresonanzvorrichtung ladbar ist und Programmmittel, z.B. Bibliotheken und Hilfsfunktionen, aufweist, um ein vorgeschlagenes Verfahren auszuführen, wenn das Computerprogrammprodukt in der Systemsteuereinheit der Magnetresonanzvorrichtung ausgeführt wird. Das Computerprogrammprodukt kann dabei eine Software mit einen Quellcode, der noch kompiliert und gebunden oder der nur interpretiert werden muss, oder einen ausführbaren Softwarecode umfassen, der zur Ausführung nur noch in die Systemsteuereinheit zu laden ist.

Durch das Computerprogrammprodukt kann das vorgeschlagene Verfahren vorteilhafterweise schnell, identisch wiederholbar und robust ausgeführt werden. Das Computerprogrammprodukt ist vorzugsweise so konfiguriert, dass es mittels der Systemsteuereinheit die vorgeschlagenen Verfahrensschritte ausführen kann. Die Systemsteuereinheit weist dabei jeweils die Voraussetzungen wie beispielsweise einen entsprechenden Arbeitsspeicher, eine entsprechende Grafikkarte oder eine entsprechende Logikeinheit auf, so dass die jeweiligen Verfahrensschritte effizient ausgeführt werden können.

Das Computerprogrammprodukt ist beispielsweise auf einem computerlesbaren Medium gespeichert oder auf einem Netzwerk oder Server hinterlegt, von wo es in den Prozessor einer lokalen Systemsteuereinheit geladen werden kann, der mit der Magnetresonanzvorrichtung direkt verbunden oder als Teil der Magnetresonanzvorrichtung ausgebildet sein kann. Weiterhin können Steuerinformationen des Computerprogrammprodukts auf einem elektronisch lesbaren Datenträger gespeichert sein. Die Steuerinformationen des elektronisch lesbaren Datenträgers können derart ausgestaltet sein, dass sie bei Verwendung des Datenträgers in einer Systemsteuereinheit einer Magnetresonanzvorrichtung ein vorgeschlagenes Verfahren durchführen.

Beispiele für elektronische lesbare Datenträger sind eine DVD, ein Magnetband oder einen USB-Stick, auf welchem elektronisch lesbare Steuerinformationen, insbesondere Software, gespeichert ist. Wenn diese Steuerinformationen von dem Datenträger gelesen und in eine Systemsteuereinheit der Magnetresonanzvorrichtung gespeichert werden, können vorteilhafterweise alle vorgeschlagenen Ausführungsformen des vorab beschriebenen Verfahrens durchgeführt werden.

Weitere Vorteile, Merkmale und Einzelheiten der Erfindung ergeben sich aus den im Folgenden beschriebenen Ausführungsbeispielen sowie anhand der Zeichnungen. Einander entsprechende Teile sind in allen Figuren mit den gleichen Bezugszeichen versehen.

Es zeigen:
- Fig. 1: eine Magnetresonanzvorrichtung in einer schematischen Darstellung,
- Fig. 2: ein Verfahren zum Kalibrieren einer Bewegungsdetektionsmethode in einer schematischen Darstellung und
- Fig. 3 und 4: Darstellungen zweiter Bewegungsdaten.

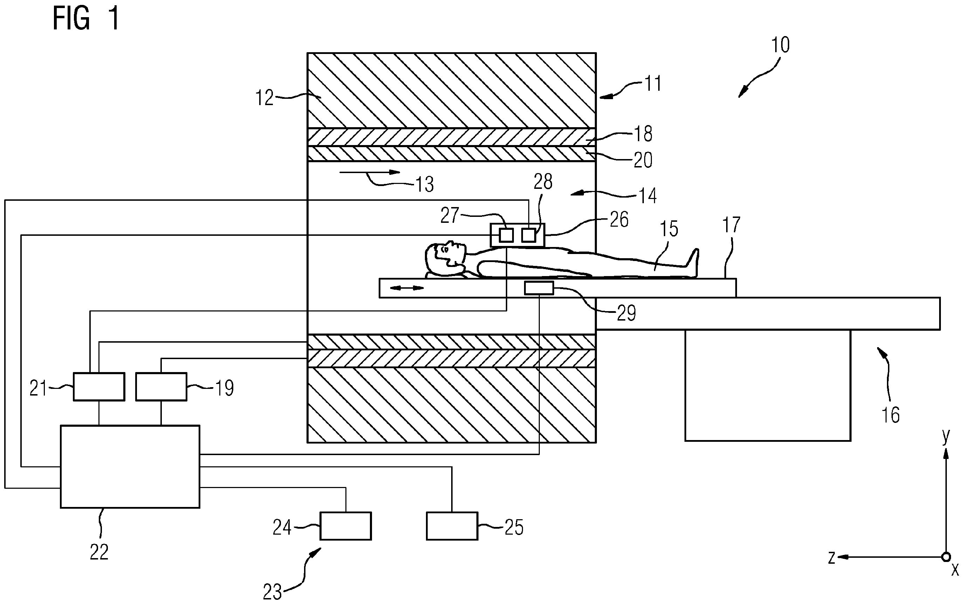

In Fig. 1 ist eine Magnetresonanzvorrichtung 10 schematisch dargestellt. Die Magnetresonanzvorrichtung 10 umfasst eine Magneteinheit 11, die einen Hauptmagneten 12 zu einem Erzeugen eines starken und insbesondere zeitlich konstanten Hauptmagnetfelds 13, auch B0-Feld genannt, aufweist. Zudem umfasst die Magnetresonanzvorrichtung 10 einen Patientenaufnahmebereich 14, insbesondere in Form eines Tunnels, zu einer Aufnahme eines Patienten 15 als Untersuchungsobjekt. Der Patientenaufnahmebereich 14 im vorliegenden Ausführungsbeispiel ist zylinderförmig ausgebildet und in einer Umfangsrichtung von der Magneteinheit 11 zylinderförmig umgeben. Grundsätzlich ist jedoch eine davon abweichende Ausbildung des Patientenaufnahmebereichs 14 jederzeit denkbar. Der Patient 15 kann mittels einer Patientenlagerungsvorrichtung 16 der Magnetresonanzvorrichtung 10 in den Patientenaufnahmebereich 14 geschoben werden. Die Patientenlagerungsvorrichtung 16 weist hierzu einen innerhalb des Patientenaufnahmebereichs 14 bewegbar ausgestalteten Patiententisch 17 auf.

Die Magneteinheit 11 weist weiterhin eine Gradientenspuleneinheit 18 zu einer Erzeugung eines Gradientenmagnetfeldes auf, das für eine Ortskodierung während einer Bildgebung verwendet wird. Die Gradientenspuleneinheit 18 wird mittels einer Gradientensteuereinheit 19 der Magnetresonanzvorrichtung 10 gesteuert. Die Magneteinheit 11 umfasst weiterhin eine Hochfrequenzantenneneinheit 20, welche im vorliegenden Ausführungsbeispiel als fest in die Magnetresonanzvorrichtung 10 integrierte Körperspule ausgebildet ist. Die Hochfrequenzantenneneinheit 20 wird von einer Hochfrequenzantennensteuereinheit 21 der Magnetresonanzvorrichtung 10 gesteuert und strahlt hochfrequente Anregungspulse in einen Untersuchungsraum ein, der im Wesentlichen von einem Patientenaufnahmebereich 14 der Magnetresonanzvorrichtung 10 gebildet ist. Dadurch stellt sich dem von dem Hauptmagneten 12 erzeugten Hauptmagnetfeld 13 eine Anregung von Atomkernen ein. Durch Relaxation der angeregten Atomkerne werden Magnetresonanzsignale erzeugt. Die Hochfrequenzantenneneinheit 20 ist zum Empfang der Magnetresonanzsignale ausgebildet, stellt also einen Teil einer HF-Empfangseinheit der Magnetresonanzvorrichtung dar.

Ferner umfasst die Magnetresonanzvorrichtung 10, insbesondere als Teil der Hochfrequenzantenneneinheit 20, eine Lokalspule 26, die auf der Brust des Patienten 15 angeordnet ist. Die Lokalspule 26 kann beispielsweise mit Gurten am Patienten 15 festgeschnallt werden. Eine solche Lokalspule 26 ist beispielsweise eine Body-Array-Spule mit mehreren Spulenelementen. Die Lokalspule 26 ist also eine am Patienten 15 angebrachte Komponente der Magnetresonanzvorrichtung, die durch die Bewegung des Patienten 15, insbesondere durch eine Bewegung einer Brust des Patienten 15, mitbewegt wird. Die Lokalspule 26 ist zum Empfang der Magnetresonanzsignale ausgebildet. Vorteilhafterweise wird die Lokalspule 26 in der Nähe des Bereichs des Patienten 15 angebracht, der mittels einer Magnetresonanzmessung aufgenommen werden soll. Die in diesem Bereich entstehenden Magnetresonanzsignale können dadurch mit einem besonders hohem Signal-Rausch-Verhältnis erfasst werden. Es ist auch denkbar, dass die Lokalspule 26 zum Senden von hochfrequenten Anregungspulsen ausgebildet ist.

Zu einer Steuerung des Hauptmagneten 12, der Gradientensteuereinheit 19 und zur Steuerung der Hochfrequenzantennensteuereinheit 21 weist die Magnetresonanzvorrichtung 10 eine Systemsteuereinheit 22 auf. Die Systemsteuereinheit 22 steuert zentral die Magnetresonanzvorrichtung 10, wie insbesondere das Durchführen einer Magnetresonanzsequenz. Zudem umfasst die Systemsteuereinheit 22 eine nicht näher dargestellte Auswerteeinheit zu einer Auswertung der Magnetresonanzsignale, die während der Magnetresonanzuntersuchung erfasst werden. Des Weiteren umfasst die Magnetresonanzvorrichtung 10 eine Benutzerschnittstelle 23, die mit der Systemsteuereinheit 22 verbunden ist. Steuerinformationen wie beispielsweise Bildgebungsparameter, sowie rekonstruierte Magnetresonanzabbildungen können auf einer Anzeigeeinheit 24, beispielsweise auf zumindest einem Monitor, der Benutzerschnittstelle 23 für ein medizinisches Bedienpersonal angezeigt werden. Weiterhin weist die Benutzerschnittstelle 23 eine Eingabeeinheit 25 auf, mittels der Informationen und/oder Parameter während eines Messvorgangs von dem medizinischen Bedienpersonal eingegeben werden können.

Zur Durchführung einer zu kalibrierenden (ersten) Bewegungsdetektionsmethode, der PT-Methode, umfasst die Magnetresonanzvorrichtung ferner einen Pilotton-Generator 29, der hier im Patiententisch 17 angeordnet ist. Die PT-Methode ist eine elektromagnetische, berührungslose Bewegungsdetektionsmethode. Gemäß dieser Methode sendet der PT-Generator ein PT-Signal aus, das durch eine Bewegung des Patienten 15 moduliert und von der HF-Empfangseinheit der Magnetresonanzvorrichtung 10, insbesondere von der Lokalspule 26, als erste Bewegungsdaten erfasst wird. Somit umfasst diese Bewegungsdetektionsmethode eine Wechselwirkung des PT-Signals mit dem sich bewegenden Patienten 15. Der PT-Generator 29 kann beispielsweise mittels der Systemsteuereinheit 22 gesteuert werden. Vorteilhafterweise weist die Lokalspule 26 eine Empfangsbandbreite auf, die groß genug ist, um gleichzeitig das Magnetresonanzsignal und PT-Signal, das nicht im Frequenzbereich des MR-Signals liegt, zu empfangen. Die Lokalspule 26 kann mehrere Empfangselemente, insbesondere Spulenelemente, umfassen, die jeweils einem Empfangskanal zugeordnet sind.

Die Lokalspule 26 umfasst einen Magnetfeld-Sensors in Form eines Hall-Sensors 27 und einen Beschleunigungssensor 28, mit denen gemäß weiterer Bewegungsdetektionsmethoden zweite Bewegungsdaten erfasst werden können. Die Magnetresonanzvorrichtung kann noch weitere Sensoren zur Erfassung zweiter Bewegungsdaten erfassen, wie beispielsweise einen Gyro-Sensor. Die Sensoren 27, 28 sind hier beispielhaft in der Lokalspule 26 integriert. Durch die Bewegung des Untersuchungsobjekts, insbesondere durch die Bewegung der Brust des Patienten 15, werden die Sensoren 27, 28 zusammen mit der Lokalspule 26 mitbewegt. Insbesondere in Untersuchungen des Herzens und/oder des Abdomens und/oder der Brust des Patienten kann auf diese Weise eine mechanische Verbindung der Sensoren 27, 28 mit der Brustbewegung herstellt werden.

Mit den Sensoren 27, 28 können zweite Bewegungsdaten aufgenommen werden, weshalb die Sensoren 27, 28 als Bewegungssensoren bezeichnet werden können. Der Hall-Sensor 27 und der Beschleunigungssensor 28 beruhen auf unterschiedlichen physikalischen Wechselwirkungen zur Detektion der Bewegung des Patienten 15. Während der Hall-Sensor 27 mit dem Hauptmagnetfeld 13 wechselwirkt und somit die Signalerzeugung auf einer magnetischen Kraft beruht, beruht die Signalerzeugung des Beschleunigungssensors 28 auf der Trägheitskraft.

Die Sensoren 27, 28 sind in Fig. 1 innerhalb des Tunnels des Magnetresonanzvorrichtung angeordnet. Die Erfassung der zweiten Bewegungsdaten durch die Sensoren 27, 28 kann jedoch auch ganz oder teilweise außerhalb des Tunnels erfolgen.

Innerhalb des Tunnels ist das Hauptmagnetfeld 13 üblicherweise sehr homogen, so dass eine Auflösung eines typischen Hallsensors (z.B. 0,1 mT) in der Regel nicht ausreicht, um typische Feldinhomogenitäten (z.B. 500 nT) zu detektieren. Daher können in der Regel im Tunnel nicht ohne weiteres Translationskoordinaten (z.B. x, y, z) bestimmt werden. Insbesondere in dem in Fig. 1 gezeigten Fall, in dem die Lokalspule 26 beispielsweise um den Patienten 15 gewickelt ist, resultieren üblicherweise keine größeren TranslationsBewegungen der Sensoren 27, 28 durch beispielsweise Atmen und/oder Husten des Patienten 15; solche Bewegungen betragen üblicherweise maximal wenige Zentimeter. Jedoch umfassen solche Bewegungen üblicherweise neben dem Translationsanteil auch einen Rotationsanteil, also Rotationsbewegungen wie z.B. Drehung, Kippung und/oder Neigung. Vorteilhafterweise können solche Rotationsbewegungen als zweite Bewegungsdaten sehr genau bestimmt werden. Das homogene Hauptmagnetfeld 13 hat üblicherweise im Tunnel nur eine Komponente B0_{z} ungleich Null. Die Komponenten B0ₓ und B0_{y} sind üblicherweise gleich Null. Einen Anteil der Rotationsbewegung der Spule kann man somit aus den veränderten Bewegungsdaten Hallₓ, Hall_{Y}, Hall_{Z} des Hallsensors berechnet werden: Hallₓ, Hall_{Y}, Hall_{Z} ändern sich als Projektionen der Magnetfeldkomponente B0_{z} auch im homogenen Hauptmagnetfeld 13 des Tunnels.

Die Sensoren 27, 28 übertragen die erfassten zweiten Bewegungsdaten an die Systemsteuereinheit 22 zur weiteren Auswertung.

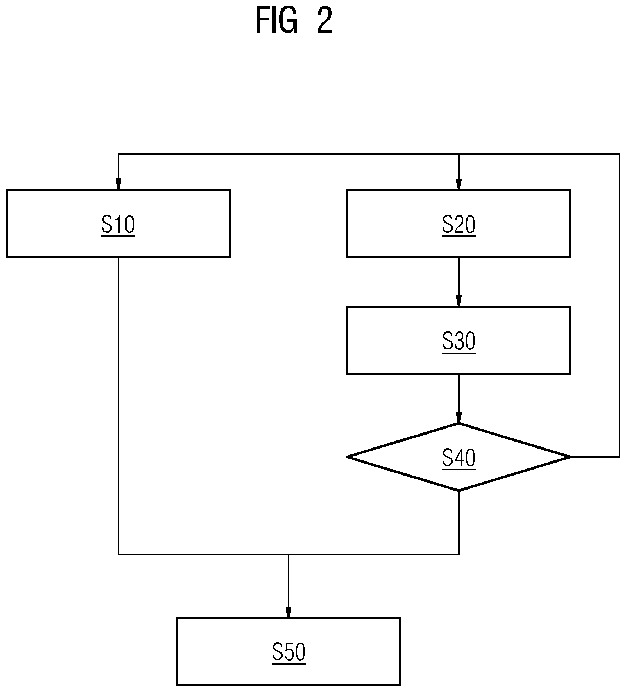

In Fig. 2 wird ein Verfahren zum Kalibrieren einer Bewegungsdetektionsmethode dargestellt, wie beispielsweise die oben erläuterte PT-Methode. Dabei werden in S10 erste Bewegungsdaten des Patienten 15 gemäß der zu kalibrierenden Bewegungsdetektionsmethode erfasst. In S20 werden während des Erfassens der ersten Bewegungsdaten zweite Bewegungsdaten des Patienten 15 gemäß zumindest einer weiteren Bewegungsdetektionsmethode fasst, wie beispielsweise mittels des Hall-Sensors 27 und/oder des Beschleunigungssensors 28. Die zweiten Bewegungsdaten beschreiben insbesondere die Position der Lokalspule 26 in Bezug auf das Hauptmagnetfeld 13 und ihre Beschleunigung.

Der Zeitraum von S10 und S20 kann als Lernphase betrachtet werden. Die in dieser Lernphase aufgezeichneten zweiten Bewegungsdaten werden beispielsweise in einem Speichermodul, insbesondere einem RAM, der Systemsteuereinheit gespeichert.

In S50 wird zu kalibrierende Bewegungsdetektionsmethode anhand der in S10 und S20 erfassten ersten und zweiten Bewegungsdaten kalibriert. Dazu wird vorzugsweise vorher in S30 anhand der zweiten Bewegungsdaten zumindest ein Störungszeitraum identifiziert, der während des Erfassens der ersten Bewegungsdaten und der zweiten Bewegungsdaten aufgetreten ist. In dem zumindest einen Störungszeitraum weist die Bewegung des Untersuchungsobjekts eine Störung auf.

Insbesondere werden nach Abschluss der Trainingsphase in S10 und S20 die gespeicherten zweiten Bewegungsdaten in S30 analysiert, um problematische Bewegungsmuster (z.B. plötzliche Beschleunigungs- und Positionsspitzen durch Husten) zu erkennen, die auf einen Störungszeitraum hindeuten.

In S40 kann anhand der zweiten Bewegungsdaten überprüft werden, ob die Bewegung des Patienten 15 im Erfassungszeitraum zumindest einem vorgegebenen Kriterium entspricht, insbesondere hinreichend regelmäßig ist. Falls dies der Fall ist, kann das Kalibrieren in S50 ohne Weiteres durchgeführt werden. Falls dies nicht der Fall ist, werden S10, S20, S30 und S40 wiederholt durchgeführt.

In S50 erfolgt dann die Kalibrierung der zu kalibrierenden Bewegungsdetektionsmethode, insbesondere der PT-Methode, unter Berücksichtigung des zumindest einen Störungszeitraums.

Die Bewegung der Brust des Patienten 15 umfasst mit Herz- und Atembewegung zwei Bewegungsbestandteile. Beispielsweise werden in jedem Empfangskanal der gemäß der PT-Methode erfassten ersten Bewegungsdaten die Herz- und Atembewegung durch eine zunächst unbekannte Mischmatrix linear gemischt. Um Atem- und Herzbewegung ohne zusätzliche Informationen zu trennen, wird vorzugsweise ein BSS-Algorithmus, insbesondere ein ICA-Algorithmus und/oder einen PCA-Algorithmus, verwendet, der mit Hilfe der zweiten Bewegungsdaten kalibriert werden kann. Diese Algorithmen benötigen zu ihrer Kalibrierung üblicherweise einen Trainingsdatensatz erster Bewegungsdaten von ca. 10-20 Sekunden, in denen der Patient 15 normal atmen sollte, um eine Entmischungslösung bestimmen zu können, die Herz- und Atembewegung trennt.

Jedoch ist es möglich, dass der Patient 15 während dieser Trainingsphase unwillkürliche Bewegungen ausführt, wie z.B. Husten, Verdrehen, Schluckauf usw. Solche Störungen, insbesondere Bewegungsabweichungen, können in S30 anhand der zweiten Bewegungsdaten identifiziert und in S50 berücksichtigt werden.

Insbesondere kann vorteilhafterweise aus den in S30 identifizierten Störungen auf die Qualität der ersten Bewegungsdaten geschlossen werden. Sofern die zweiten Bewegungsdaten eine Bewegung des Patienten 15 zeigen, kann davon ausgegangen werden, dass die zeitlich aufgenommenen ersten Bewegungsdaten, insbesondere PT-Daten, nicht zur Kalibrierung der zu kalibrierenden Bewegungsdetektionsmethode, insbesondere der PT-Methode, geeignet sind.

Wenn etwa die zweiten Bewegungsdaten auf eine die ersten Bewegungsdaten in einem hinreichend großen Teil der Trainingsphase kontaminierende Bewegung des Patienten 15 hindeuten, sollte die Trainingsphase, insbesondere automatisch, wiederholt werden. Wenn die zweiten Bewegungsdaten darauf hindeuten, dass die ersten Bewegungsdaten nicht bewegungskontaminiert sind oder nur in einem kleinen Teil der Trainingsphase, dann können diese Störungszeiträume identifiziert werden. Die in diesen Störungszeiträumen liegenden ersten Bewegungsdaten können bei der Kalibrierung der zu kalibrierenden Bewegungsdetektionsmethode ignoriert werden, so dass die Kalibrierung nur anhand der außerhalb der Störungszeiträume liegenden (also nicht-bewegungskontaminierten) ersten Bewegungsdaten durchgeführt wird. Insbesondere werden die ersten Bewegungsdaten modifiziert, indem die ersten Bewegungsdaten innerhalb der Störungszeiträume entfernt werden, und die Kalibrierung in S50 erfolgt dann mit den modifizierten ersten Bewegungsdaten. Vorteilhafterweise braucht die Trainingsphase dann nicht wiederholt zu werden, so dass Zeit eingespart werden kann.

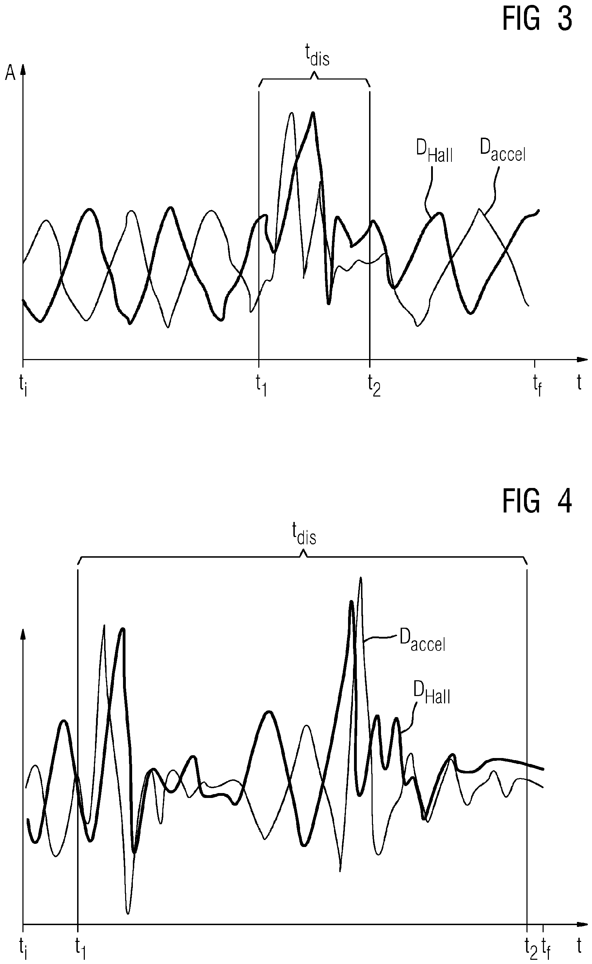

In Fig. 3 und Fig. 4 werden zweite Bewegungsdaten in Abhängigkeit der Zeit t beispielhaft gezeigt. Dabei sind jeweils von dem Hall-Sensor 27 aufgenommene Bewegungsdaten D_{Hall} als ein erster Teil der zweiten Bewegungsdaten und dem Beschleunigungssensor 28 aufgenommene Bewegungsdaten D_{accel} ein zweiter Teil der zweiten Bewegungsdaten dargestellt. Anhand dieser zweite Bewegungsdaten kann in S40 geprüft werden, ob die Trainingsphase wiederholt werden sollte.

Die in Fig. 3 dargestellten zweiten Bewegungsdaten sind nur in einem kleinen Intervall t_{dis} der von tᵢ bis t_{f} dauernden Trainingsphase wird durch ungewollte Bewegung des Patienten 15 gestört, so dass die außerhalb von t_{dis} (also von tᵢ bis t₁ und von t₂ bis t_{f}) liegenden ersten Bewegungsdaten ausreichen, um eine Entmischungslösung zu berechnen. Die Trainingsphase braucht in diesem Fall nicht wiederholt werden.

Dagegen sind die meisten der in Fig. 4 dargestellten zweiten Bewegungsdaten durch Bewegung kontaminiert. In diesem Fall sollte die Trainingsphase muss in diesem Fall wiederholt werden. Die Wiederholung erfolgt vorteilhafterweise automatisch, so dass keine Interaktion des Bedienpersonals erforderlich ist.

Es wird abschließend noch einmal darauf hingewiesen, dass es sich bei den vorhergehend detailliert beschriebenen Verfahren sowie bei der dargestellten Systemsteuereinheit und Magnetresonanzvorrichtung lediglich um Ausführungsbeispiele handelt, welche vom Fachmann in verschiedenster Weise modifiziert werden können, ohne den Bereich der Erfindung zu verlassen. Weiterhin schließt die Verwendung der unbestimmten Artikel "ein" bzw. "eine" nicht aus, dass die betreffenden Merkmale auch mehrfach vorhanden sein können. Ebenso schließt der Begriff "Einheit" nicht aus, dass die betreffenden Komponenten aus mehreren zusammenwirkenden Teil-Komponenten bestehen, die gegebenenfalls auch räumlich verteilt sein können.

## Patentansprüche

1. Computerimplementiertes Verfahren zum Kalibrieren einer Bewegungsdetektionsmethode, BDM, wobei die BDM geeignet ist, eine Bewegung eines Untersuchungsobjekts während einer Magnetresonanzmessung mittels einer Magnetresonanzvorrichtung zu detektieren, wobei das Verfahren umfasst:
- Erfassen erster Bewegungsdaten des Untersuchungsobjekts in einem Erfassungszeitraum gemäß der BDM,
- Erfassen zweiter Bewegungsdaten des Untersuchungsobjekts gemäß zumindest einer weiteren Bewegungsdetektionsmethode in dem Erfassungszeitraum,
- Kalibrieren der BDM anhand der ersten Bewegungsdaten und der zweiten Bewegungsdaten.

2. Verfahren nach Anspruch 1,
wobei das Kalibrieren der BDM anhand der ersten Bewegungsdaten und der zweiten Bewegungsdaten ein Identifizieren zumindest eines Störungszeitraums in dem Erfassungszeitraum, in dem die Bewegung des Untersuchungsobjekts eine Störung, insbesondere Ausweichung, aufweist, anhand der zweiten Bewegungsdaten umfasst,
wobei die BDM unter Berücksichtigung des zumindest einen Störungszeitraums kalibriert wird.

3. Verfahren nach einem der Ansprüche 2,
wobei das Identifizieren des zumindest einen Störungszeitraums ein Identifizieren zumindest einer Bewegungsabweichung anhand der zweiten Bewegungsdaten, insbesondere zumindest eines vorbestimmten Bewegungsmusters in den zweiten Bewegungsdaten, umfasst.

4. Verfahren nach einem der vorangehenden Ansprüche,
wobei das Kalibrieren der BDM anhand der ersten Bewegungsdaten und der zweiten Bewegungsdaten ein Modifizieren der ersten Bewegungsdaten anhand der zweiten Bewegungsdaten, insbesondere ein Entfernen der ersten Bewegungsdaten innerhalb des zumindest eines Störungszeitraums aus den ersten Bewegungsdaten, und ein Kalibrieren der BDM anhand der modifizierten Bewegungsdaten umfasst.

5. Verfahren nach einem der vorangehenden Ansprüche,
wobei die Bewegung des Untersuchungsobjekts zumindest zwei Bewegungsbestandteile umfasst,
wobei das Kalibrieren der BDM ein Kalibrieren eines BSS-Algorithmus, insbesondere einen ICA-Algorithmus und/oder einen PCA-Algorithmus, zum Separieren der zumindest zwei Bewegungsbestandteile umfasst.

6. Verfahren nach einem der Ansprüche 5,
wobei die zumindest zwei Bewegungsbestandteile eine Herzbewegung und eine Atembewegung des Untersuchungsobjekts umfassen.

7. Verfahren nach einem der vorangehenden Ansprüche,
wobei die BDM eine Wechselwirkung eines Pilotton-Signals mit dem sich bewegenden Untersuchungsobjekt umfasst.

8. Verfahren nach einem der vorangehenden Ansprüche, wobei das Verfahren ferner umfasst:
- Überprüfen anhand der zweiten Bewegungsdaten, ob die Bewegung des Untersuchungsobjekts im Erfassungszeitraum zumindest einem vorgegebenen Kriterium entspricht, insbesondere hinreichend regelmäßig ist,
- falls das Überprüfen ergibt, dass die Bewegung eines Untersuchungsobjekts im Erfassungszeitraum nicht dem zumindest einen vorgegebenen Kriterium entspricht, insbesondere hinreichend regelmäßig ist: Erfassen weiterer erster und zweiter Bewegungsdaten und Kalibrieren der BDM anhand der weiteren ersten und zweiten Bewegungsdaten.

9. Verfahren nach einem der vorangehenden Ansprüche,
wobei die zweiten Bewegungsdaten mit zumindest einem Sensor erfasst werden, der durch die Bewegung des Untersuchungsobjekts, insbesondere durch eine Bewegung einer Brust des Untersuchungsobjekts, mitbewegt wird.

10. Verfahren nach einem der vorangehenden Ansprüche,
wobei die zweiten Bewegungsdaten mit zumindest einem Sensor erfasst werden, der in oder an einer am Untersuchobjekt angebrachten Komponente der Magnetresonanzvorrichtung, insbesondere einer Lokalspule, angeordnet ist, die durch die Bewegung des Untersuchungsobjekts, insbesondere durch eine Bewegung einer Brust des Untersuchungsobjekts, mitbewegt wird.

11. Verfahren nach einem der Ansprüche 9 bis 10,
wobei der zumindest eine Sensor einen Magnetfeld-Sensor, insbesondere einen Hall-Sensor, und/oder einen Beschleunigungssensor und/oder einen Gyro-Sensor umfasst.

12. Verfahren nach einem der Ansprüche 9 bis 11,
wobei der zumindest eine Sensor mehrere Sensoren umfassen, die jeweils auf einer anderen physikalischen Wechselwirkung zur Detektion der Bewegung des Untersuchungsobjekts beruhen.

13. Lokalspule mit zumindest einem Sensor zur Erfassung zweiter Bewegungssignale, um damit ein Verfahren nach einem der Ansprüche 9 bis 12 auszuführen.

14. Magnetresonanzvorrichtung, insbesondere mit einer Lokalspule nach Anspruch 13, die ausgebildet ist, ein Verfahren nach einem der Ansprüche 1 bis 12 auszuführen.

15. Computerprogrammprodukt, welches ein Programm umfasst und direkt in einen Speicher einer programmierbaren Systemsteuereinheit einer Magnetresonanzvorrichtung ladbar ist, mit Programmmitteln, um ein Verfahren nach einem der Ansprüche 1 bis 12 auszuführen, wenn das Programm in der Systemsteuereinheit der Magnetresonanzvorrichtung ausgeführt wird.
